# EUROPEAN PATENT APPLICATION

(11) **EP 3 302 008 A1**
(43) Date of publication of application: **04.04.2018**
(21) Application number: 16275144.0
(22) Date of filing: 30.09.2016
(51) Int. Cl.: H05K 1/03, H05K 3/32, H05K 3/36, H05K 5/06

(54) **AN IMPROVED METHOD AND APPARATUS**

(71) Applicant: BAE Systems PLC, London SW1Y 5AD (GB)
(72) Inventor: The designation of the inventor has not yet been filed
(74) Representative: BAE SYSTEMS plc Group IP Department

(57) **Abstract**

A method of electrically connecting an electronic textile (108, 110) to an electronic device (300), the electronic textile (108, 110) comprising an electrically insulating textile carrier (400) and one or more electrical conductor lines (402), the method comprising: positioning the electronic textile (108, 110) relative to the electronic device (300) such that each conductor line (402) is in contact with an electrical conductor (304) of the electronic device (300), thereby providing an assembly; and fixing a clamp member (500) to the assembly such that each conductor line (402) is sandwiched between the clamp member (500) and an electrical conductor (304) of the electronic device (300). The clamp member (500) may comprise one or more grooves (600), and fixing the clamp member (500) to the assembly may be such that each conductor line (402) is located within a respective groove (600).

## Description

### FIELD OF THE INVENTION

The present invention relates to electrically connecting electronic textiles to electronic devices.

### BACKGROUND

Electronic textiles (commonly referred to as "e-textiles") are typically fabrics and textiles in which are embedded electronic components, for example, conducting wires, integrated circuits, printed circuit board (PCB) assemblies, light emitting diodes (LEDs), computers, electronic displays, batteries and the like.

E-textiles are typically used as wearable technology, and may be worn by a user who may use the embedded electronic components. Examples of users who may benefit from such wearable technology include emergency services personnel (e.g. firemen and policemen), soldiers, and maintenance technicians.

Wearable technology that includes e-textiles may be used in harsh environmental conditions, including for example, wet and high temperature environments.

### SUMMARY OF THE INVENTION

In a first aspect, the present invention provides a method of electrically connecting an electronic textile to an electronic device. The electronic textile comprises an electrically insulating textile carrier and one or more electrical conductor lines. The method comprises: positioning the electronic textile relative to the electronic device such that each conductor line is in contact (e.g. direct physical contact) with an electrical conductor of the electronic device, thereby providing an assembly; and fixing a clamp member to the assembly such that each conductor line is clamped between the clamp member and an electrical conductor of the electronic device. The clamp member may be positioned such that it is in direct, physical contact with the e-textile conductors.

Fixing the clamp member to the assembly may be performed such that the clamp member applies a force to each conductor line so as to push each conductor line against an electrical conductor of the electronic device.

The clamp member may comprise one or more grooves. Fixing the clamp member to the assembly may be such that each conductor line is located within a respective groove. The clamp member may comprise one or more deformable protrusions. Fixing the clamp member to the assembly may be performed such that each deformable protrusion is deformed by contacting with the assembly. The clamp member may be an electrically insulating member.

The method may further comprise: forming a plurality of first alignment holes through the electronic device, and forming a plurality of second alignment holes through the electronic textile. Positioning the electronic textile relative to the electronic device comprises positioning the electronic textile relative to the electronic device may be performed such that each first alignment hole is aligned with a respective second alignment hole.

The clamp member may comprise a plurality of locator pins. Fixing the clamp member to the assembly may comprise positioning each locator pin through a respective pair of aligned first and second alignment holes.

The clamp member may comprise one or more structurally weakened portions.

The method may further comprise forming aperture (i.e. a window, through hole or bore) through the electronic textile by removing a portion of the textile carrier thereby exposing an intermediate portion of each conductor line. The positioning of the electronic textile relative to the electronic device may be performed such that the exposed intermediate portion of each conductor line is in contact with an electrical conductor of the electronic device. The fixing of the clamp member to the assembly may be performed such that the exposed intermediate portion of each conductor line is clamped between the clamp member and an electrical conductor of the electronic device.

The method may further comprise sealing at least part of the fixed together electronic textile, electronic device, and clamping member within an interior cavity of a casing, wherein the casing pushes together the at least part of the fixed together electronic textile, electronic device, and clamping member located therein. The casing may provide a clamping force to force together the electronic textile, the electronic device, and the clamping member. The casing may be electrically and thermally conductive. The method may further comprise filling the interior cavity of the casing with a potting compound. The potting compound may be an electrically insulating material. The potting compound may be a thermally conductive material.

In a further aspect, the present invention provides an electronic assembly comprising: an electronic device; an electronic textile comprising an electrically insulating textile carrier and one or more electrical conductor lines; and a clamp member. The electronic textile is positioned relative to the electronic device such that each conductor line is in contact with an electrical conductor of the electronic device. The clamp member is arranged such that each conductor line is clamped between the clamp member and an electrical conductor of the electronic device.

### BRIEF DESCRIPTION OF THE DRAWINGS

Figure 1 is a schematic illustration (not to scale) of a tactical vest;
Figure 2 is a process flow chart showing certain steps of a method of constructing a management module of the tactical vest;
Figure 3 is a schematic illustration (not to scale) of a printed circuit board assembly;
Figure 4 is a schematic illustration (not to scale) of an e-textile;
Figure 5 is a schematic illustration (not to scale) showing attachment of the e-textile to the printed circuit board assembly by means of a clamping bar;
Figure 6 is a schematic illustration (not to scale) of a cross section through the assembled together e-textile, printed circuit board assembly, and clamping bar; and
Figure 7 is a schematic illustration (not to scale) illustrating encasing the assembled together e-textile, printed circuit board assembly, and clamping bar.

### DETAILED DESCRIPTION

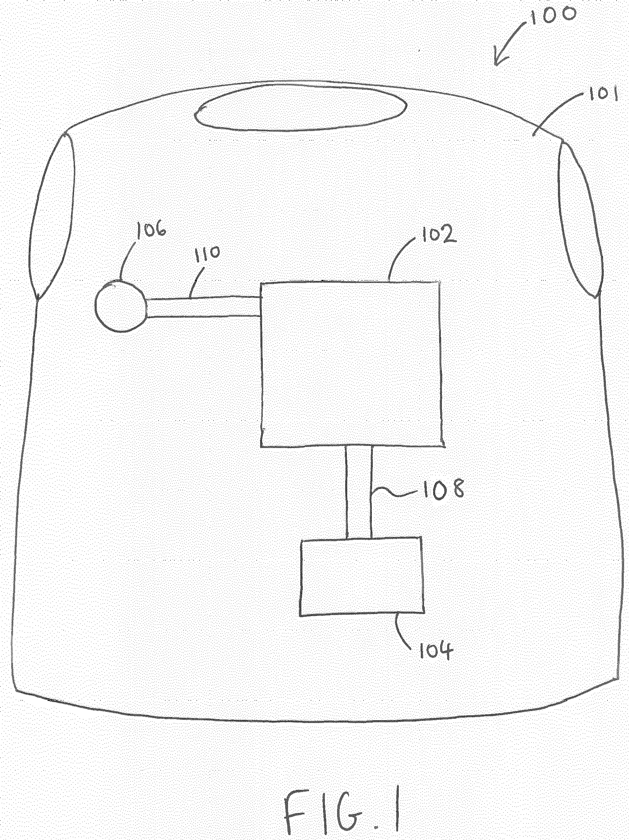

Figure 1 is a schematic illustration (not to scale) of a tactical vest 100 configured for military and/or commercial applications.

In this embodiment, the vest 100 comprises a body garment 101, a power and data manager hereinafter referred to as the "management module" 102, a power source 104, and an electrical connector 106.

The body garment 101 is configured to be worn by a user, on the user's torso. The body garment 101 comprises arm holes and a head hole through which the user places his or her arms and head respectively. In some embodiments, the body garment 101 is an item of personal armour configured to at least partially absorb impact energy and reduce or stop penetration of the user's body from, for example, firearm-fired projectiles, shrapnel, and the like. In this embodiment, the body garment 101 is made of fabric, and may optionally include panels of ballistic plate. In some embodiments, the body garment 101 is made of a waterproof material.

The body garment 101 incorporates electronic textiles, or e-textiles, to connect together the management module 102, the power source 104, and the connector 106. In particular, a first e-textile 108 electrically connects the management module 102 to the power supply 104, and a second e-textile 110 electrically connects the management module 102 to the connector 106.

In this embodiment, the vest 100 can supply suitable power for powering and/or charging one or more electronic devices (hereinafter referred to as "peripheral devices") connected to the connector 106. The vest 100 can supply, for example, 9-25V in various embodiments. In this embodiment, the management module 102 is configured to regulate electrical power from the power supply 104 to a peripheral device attached to the connector 106 according to, for example, power requirements of that peripheral device. Also, in this embodiment, the management module 102 is configured to regulate electrical power from a peripheral device acting as an external power source attached to the connector 106 to the power supply 104 and/or a further peripheral device attached to a further connector.

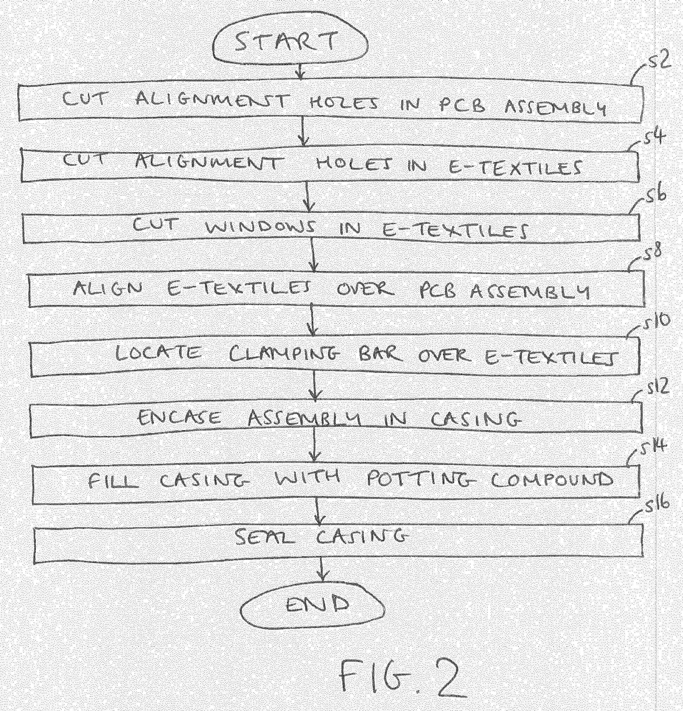

The management module 102 and its connections to the e-textiles 108, 110 is described in more detail later below with reference to Figures 2 to 7.

In this embodiment, the power supply 104 is a rechargeable battery. The power supply 104 may be located in a sealable pocket in the body garment 101, for example, at the back of the body garment 101. The pocket in which the power supply 104 is located may be waterproof.

In this embodiment, the connector 106 is an electrical connector (i.e. a plug or a jack) configured to receive one or more peripheral devices. Examples of peripheral devices include, but are not limited to, mobile telephones, computing devices such as tablet computers, torches, or and supplementary power sources such as further rechargeable batteries or solar panels.

In some embodiments, the vest 100 includes removable covers for the connector 106 to cover the connector 106 when it is not connected to a peripheral device.

What will now be described with reference to Figures 2 to 7 is further details of the management module 102, its construction, and its connection to the e-textiles 108, 110.

Figure 2 is a schematic illustration (not to scale) showing a method of constructing the management module 102.

It should be noted that certain of the process steps depicted in the flowchart of Figure 2 and described below may be omitted or such process steps may be performed in differing order to that presented above and shown in Figure 2. Furthermore, although all the process steps have, for convenience and ease of understanding, been depicted as discrete temporally-sequential steps, nevertheless some of the process steps may in fact be performed simultaneously or at least overlapping to some extent temporally. Furthermore, the process steps may be performed continuously.

At step s2, a printed circuit board (PCB) assembly is provided and a plurality of alignment holes are cut into the PCB assembly.

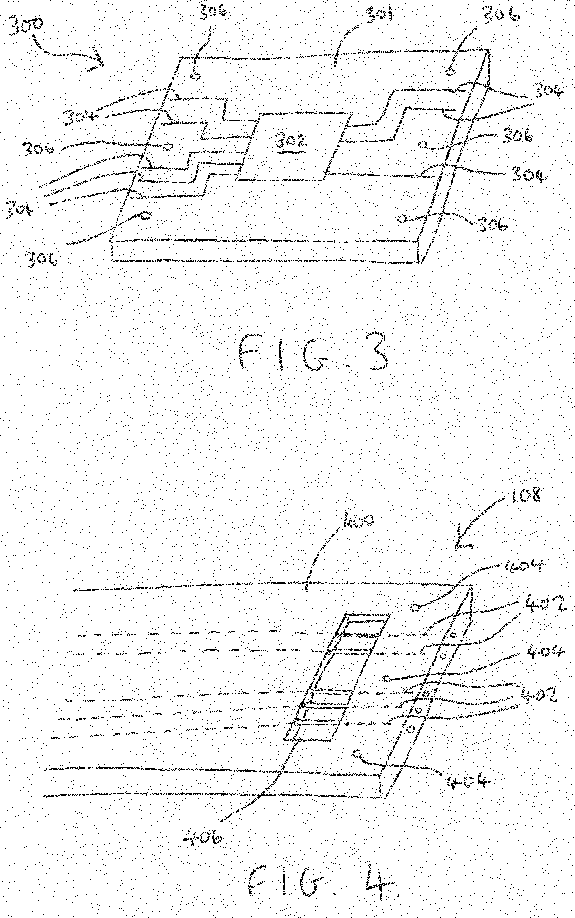

Figure 3 is a schematic illustration (not to scale) showing the PCB assembly 300 at step s2.

In this embodiment, the PCB assembly 300 comprises a non-conductive substrate 301 and a processor 302.

The processor 302 is configured to control the transfer of electrical power between the power supply 104 and the connector 106. The processor 302 comprises electronic components, such as capacitors, resistors and active devices, which may be mounted on or embedded in the substrate 301. The electronic components of the processor 302 may be coupled together by conductive tracks, pads, and/or other features of the PCB assembly 300. The processor 302 occupies a central portion of the substrate 301.

The PCB assembly 300 may, for example, be single sided, double sided, or multi-layer.

The PCB assembly 300 further comprises a plurality of conductive tracks 304. The conductive tracks 304 may, for example, be etched from copper sheets laminated onto the non-conductive substrate 301. In this embodiment, each conductive track 304 has a first end and a second end opposite to the first end. The first ends of the conductive tracks 304 are located at or proximate to an edge of the substrate 301. The second ends of the conductive tracks 304 are connected to the processor 302.

In this embodiment, the PCB assembly 300 further comprises a plurality of alignment holes 306, which are formed at step s2. The alignment holes 306 are through holes passing through the PCB assembly 300 from an upper surface of the substrate 301 to a lower surface of the substrate 301. In this embodiment, the alignment holes are cut into the substrate 301 using a computer numerical control (CNC) cutting machine comprising a laser cutter.

Returning to the description of Figure 2, at step s4, the CNC drilling machine cuts further alignment holes through each of the e-textiles 108, 110.

At step s6, the CNC drilling machine cuts a window, or an aperture, into each of the e-textiles 108, 110.

Figure 4 is a schematic illustration (not to scale) showing the first e-textile 108 at step s6. The second e-textile 110 has similar construction to that of the first e-textile 108 shown in Figure 4.

In this embodiment, the first e-textile 108 comprises an electrical insulator layer 400 into which is woven a plurality of uninsulated conductors 402.

The insulator layer 400 is a woven fabric material comprising interwoven non-electrically conductive yarns or fibres, for example polyester yarns.

Each uninsulated conductor 402 comprises a plurality of electrically conductive yarns or fibres that are interwoven with the non-conductive yarns of the insulator layer 400. The uninsulated conductors 402 form a plurality of electrically conductive lines through the insulator layer 400. The uninsulated conductors 402 may, for example, be electrically isolated from one another by the insulator layer 400.

The first e-textile 108 comprises a plurality of further alignment holes 404, which are formed at step s4. The further alignment holes 404 are through holes passing through first e-textile 108 from an upper surface of the first e-textile 108 to a lower surface of the first e-textile 108. In this embodiment, the further alignment holes 404 are cut into first e-textile 108 using the computer numerical control (CNC) cutting machine.

The first e-textile 108 further comprises a window 406, which is formed at step s6. The window 406 is a through hole passing through first e-textile 108 from the upper surface of the first e-textile 108 to the lower surface of the first e-textile 108. In this embodiment, the window 406 is spaced apart from the edges of the first e-textile 108 such that the insulator layer 400 surrounds the window 406 along each side edge of the window 406.

In this embodiment, the window 406 is elongate in a direction that is substantially perpendicular to the uninsulated conductors 402. Also, the window 406 intersects with each of the conductors 402 in the first e-textile 108 such that each of those conductors 402 is exposed within the window 406. The window 406 being spaced apart from the edges of the first e-textile 108 advantageously tends to provide that only intermediate (i.e. non-end) portions of the conductors 402 are exposed. In other words, opposite ends of the exposed portions of the conductors 402 are held by (i.e. woven into or embedded in) the insulator layer 400. This advantageously tends to prevent or oppose fraying of the conductors 402.

In this embodiment, the window 106 is cut into the first e-textile 108 using the computer numerical control (CNC) cutting machine. In particular, a laser cutter is used to form the window 406 in the first e-textile 108 by vapourising or melting away a portion of the insulator layer 400 using a laser beam. The conductors 402 are not removed by the laser beam of the laser cutter, and are thus exposed within the window 406.

Advantageously, when forming the further alignment holes 404 and the window 406, the laser cutter tends to cut and simultaneously "cauterise" the multi-strand insulator layer 400. In particular, along the cut edges, the fibres of the insulator layer 400 are welded together by the action of the laser cutter. This advantageously tends to oppose or eliminate fraying of the insulator layer 400 along the cut edges, i.e. at the boundaries of the alignment holes 404 and the window 406. Furthermore, the conductors 402 tend to be embedded in the agglomerated fibres of the insulator layer 400 along the edges of the window 406. Thus, fraying of the conductors 402 tends to be reduced.

Returning to the description of Figure 2, at step s8, the e-textiles 108, 110 are aligned over the PCB assembly 300 such that each further alignment hole 404 of the e-textiles 108, 110 is aligned with a respective alignment hole 306 of the PCB assembly 300. This alignment may be performed, for example, by a human or by an assembly robot.

In this embodiment, for the first e-textile 108, the relative positions of the further alignment holes 404 on the first e-textile 108 are substantially the same as the relative positions of a same number of alignment holes 306 on the PCB assembly 300. Thus, when the first e-textile 108 is positioned over the PCB assembly 300, each further alignment hole 404 on the first e-textile 108 aligns with a respective alignment hole 306.

Also, the first e-textile 108 and the PCB assembly 300 are designed such that, when the first e-textile 108 is positioned on top of the PCB assembly 300 to align the further alignment holes 404 with respective alignment holes 306, the exposed conductors 402 within the window 406 are positioned over and in contact with conductive tracks 304 of the PCB assembly 300 to which they are to be electrically connected.

Similarly, for the second e-textile 110, the relative positions of further alignment holes on the second e-textile 110 are substantially the same as the relative positions of a same number of alignment holes 306 on the PCB assembly 300. Thus, when the second e-textile 110 is positioned over the PCB assembly 300, each further alignment holes on the second e-textile 110 aligns with a respective alignment hole 306. Also, the second e-textile 110and the PCB assembly 300 are designed such that, when the second e-textile 110 is positioned on top of the PCB assembly 300 to align the further alignment holes of the second e-textile 110 with respective alignment holes 306, the exposed conductors within a window of the second e-textile 110 are positioned over and in contact with conductive tracks 304 of the PCB assembly 300 to which they are to be electrically connected.

In some embodiments, the e-textiles 108, 110 and/or the PCB assembly 300 are designed simultaneously using a computer, e.g. using a computer aided design software tool, and subsequently produced. For example, digital models of the first and/or second e-textiles 108, 110 and the PCB assembly 300 may be used to design a layout of the conductive tracks 304 of the PCB assembly 300, to ensure connection with the conductors 402 at step s8. The conductive track 304 may be subsequently etched using the determined design. Also for example, digital models of the first and/or second e-textiles 108 and the PCB assembly 300 may be used to determine placement of the alignment holes 306, 404. The alignment holes 306 and further alignment holes 404 may be subsequently cut into the PCB assembly 300 and e-textiles 108, 110 using the determined design.

At step s10, a clamping bar is fixed to the assembly comprising the aligned e-textiles 108, 110 and PCB assembly 300. This may be performed, for example, by a human or by an assembly robot.

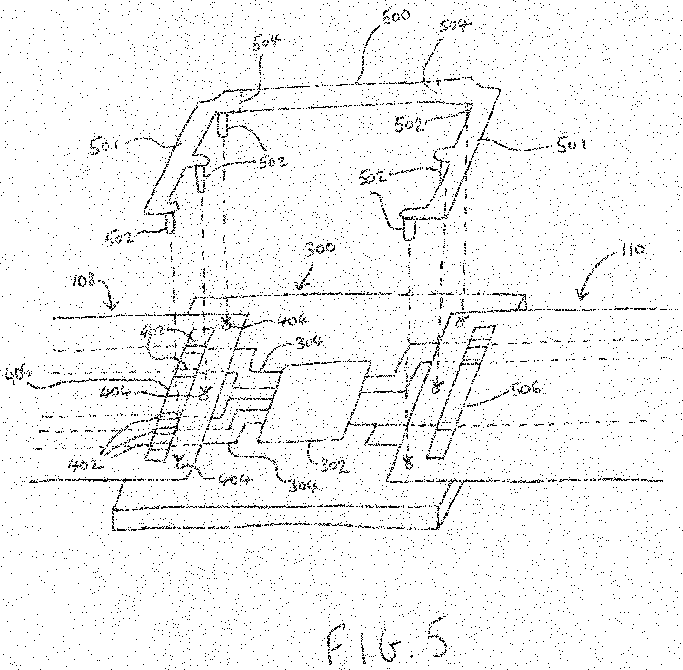

Figure 5 is a schematic illustration (not to scale) showing the e-textiles 108, 110 aligned over the PCB assembly 300, and illustrating the fixing of the clamping bar 500 over the e-textiles 108, 110. The clamping bar 500 is fitted to the e-textiles 108, 110 and PCB assembly 300 as illustrated in Figure 5 by dashed arrows.

In this embodiment, the e-textiles 108, 110 are aligned over the PCB assembly 300 such that each further alignment hole 404 of an e-textile 108, 110 is aligned with a respective alignment hole 306 of the PCB assembly 300. Also, the e-textiles 108, 110 are aligned over the PCB assembly 300 such that each exposed conductor 402 within a window 406 is over, and in contact with, a conductive track 304 to which it is to be electrically connected.

In this embodiment, the clamping bar 500 is fixed to the assembly comprising the aligned e-textiles 108, 110 and PCB assembly 300 such that that each exposed conductor 402 within a window 406 is forced against a conductive track 304 over which it is positioned, thus providing that the conductors of the e-textiles 108, 110 are electrically connected to the conductive tracks 304. Advantageously, this "force fitting" of the conductors of the e-textiles 108, 110 to the conductive tracks 304 tends to avoid a need for soldering. Thus, a risk of unwantedly melting the insulating material 400 tends to be avoided. Also, a need for cleaning of soldered components tends to be avoided. Also, a risk of solder wicking along an e-textile tends to be avoided. Also, a use of conductive adhesives tends to be avoided. Thus, delays associated with the curing of conductive adhesives tend to be reduced or eliminated. Also, risks of unwantedly spreading conductive adhesive to other areas of the assembly tend to be reduced or eliminated.

The clamping bar 500 is made of an electrically resistant material, such as a plastic. The clamping bar 500 comprises a plurality elongate clamping portions 501, a plurality of locator pins 502, and a plurality of perforated portions 504.

The clamping bar 500 is configured such that the locator pins 502 fit through the further alignment holes 404 of the e-textiles 108, 110 and into the alignment holes 306 of the PCB assembly 300. The relative positions of the elongate clamping portions 501 and the locator pins 502 on the clamping bar 500 are such that, when the locator pins 502 are positioned through the further alignment holes 404 of the e-textiles 108, 110 and the alignment holes 306 of the PCB assembly 300, the elongate clamping portions 501 are located in respective windows of the e-textiles 108, 110, thereby force fitting the exposed conductors 402 against the conductive tracks 304. In particular, when the locator pins 502 are positioned in the alignment holes 404, 306, a first of the clamping portions 501 is located in the window 406 of the first e-textile 108 and a second of the clamping portions 501 is located in a window 506 of the second e-textile 110.

Each elongate clamping portion 501 is configured to fit snuggly into a respective window of an e-textile 108, 110. In particular, in this embodiment, the first of the clamping portions 501 has substantially the same size and shape as the window 406 in the first e-textile 108, and the second of the clamping portions 501 has substantially the same size and shape as the window 506 in the second e-textile 110.

In some embodiments, the e-textiles 108, 110, the PCB assembly 300, and/or the clamping bar 500 are designed simultaneously using a computer, e.g. using a computer aided design software tool, and subsequently produced. For example, digital models of the PCB assembly 300 and the clamping bar 500 may be used to design the clamping bar 500 to ensure that the relative positions of the locator pins 502 on the clamping bar 500 are substantially the same as the relative positions of the alignment holes 306 on the PCB assembly 300. Also for example, digital models of the e-textiles 108, 110 and the clamping bar 500 may be used to ensure that the relative positions of the further alignment holes 404 and the windows 406 are substantially the same as the relative positions of the locator pins 502 and the elongate clamping portions 501. This advantageously tends to facilitate assembly at step s10, and improve the fit between the components 108, 110, 300, 500. The clamping bar 500 may be produced using the determined digital model of the clamping bar 500, for example, using Additive Manufacturing (AM) techniques, or injection molding.

The perforated portions 504 of the clamping bar 500 are purposefully weakened areas of the clamping bar 500. In some embodiments, to facilitate the fitting of the clamping bar 500 to the aligned e-textiles 108, 110 and PCB assembly 300, the clamping bar 500 may be snapped or broken along one or more of the perforated portions 504. This advantageously tends to provide improved tolerance to tolerance build-up, and further tends to facilitate manufacture of the components and their assembly together.

Thus, at step s10, the e-textiles 108, 110 are sandwiched between the clamping bar 500 and the PCB assembly 300. The clamping bar 500 is fitted such that the clamping bar 500 forces the e-textiles 108, 110 against the PCB assembly 300. In particular, in this embodiment, the elongate clamping portions 501 force the exposed conductors 402 within the windows 406, 506 onto the conductive tracks 304 of the PCB assembly 300.

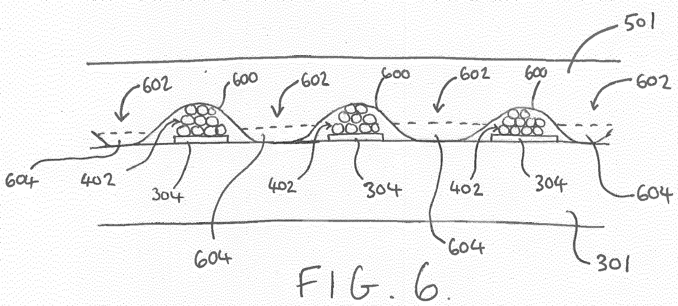

Figure 6 is a schematic illustration (not to scale) showing a cross section, through the e-textiles 108, 110, the PCB assembly 300, and the clamping bar 500. The cross section shown in Figure 6 is a view of the assembly from the position of a plane passing longitudinally through the window 406 of the first e-textile 108 and perpendicularly to the conductors 402.

In this embodiment, a lower surface of the elongate clamping portion 501 comprises a plurality of curved grooves 600 interspaced by curved projections 602.

Each uninsulated conductor 402 of the first e-textile 108 is located in a respective groove 600, i.e. for each conductor 402, the plurality of electrically conductive yarns or fibres that make up that conductor 402 is located in a respective groove 600. Locating each conductor 402 in a respective groove 600 advantageously tends to provide for improved electrical isolation of the conductors 402, and further tends to prevent or oppose fraying or splaying of the electrically conductive yarns or fibres of the conductors 402.

Each curved projection has, at its distal end, a respective deformable portion 604. In this embodiment, when the clamping bar 500 is fitted to the assembly comprising the e-textiles 108, 110 and the PCB assembly 300 at step s10, the clamping portion 501 is forced against the PCB assembly 300 causing the deformable portions 604 to deform (e.g. to crush or collapse). This advantageously tends to provide that an increased clamping force is applied to press the conductors 402 against the conductive tracks 304. This tends to provide for improved electrical connection between the conductors 402 and the conductive tracks 304, and tends to reduce the likelihood of disconnection.

In some embodiments, once the clamping bar 500 is fitted to the assembly comprising the e-textiles 108, 110 and the PCB assembly 300 at step s10 as described above, the clamping bar 500 may be held in place, for example by riveting or bolting together the clamping bar 500, the PCB assembly 300 and the e-textiles 108, 110.

Returning to the description of Figure 2, at step s12 the assembly comprising the attached together PCB assembly 300, e-textiles 108, 110, and clamping bar 500 is encased in a casing.

At step s14, the casing is filled with a potting compound.

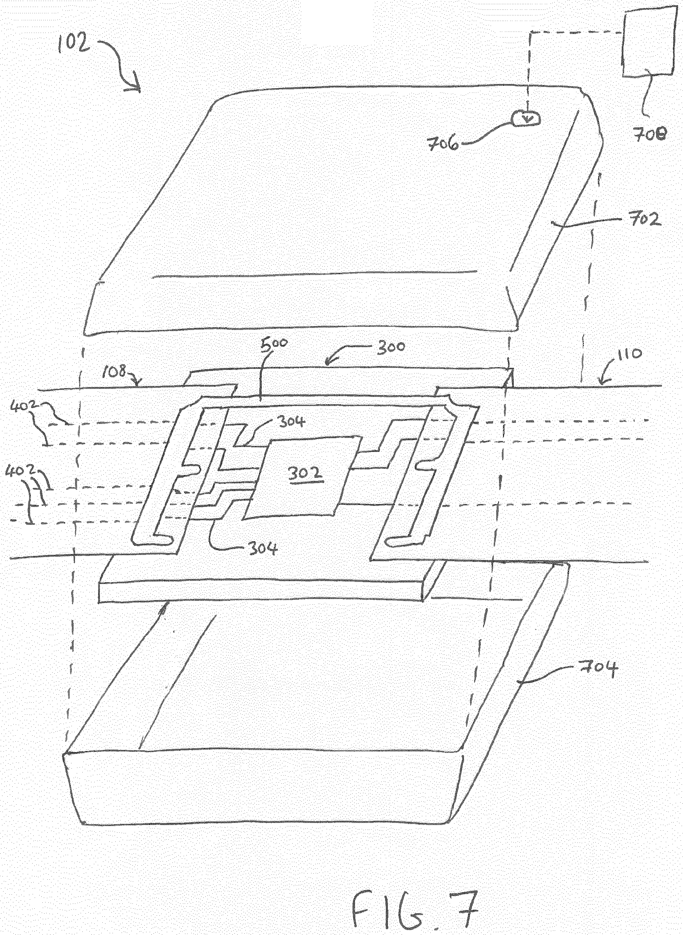

Figure 7 is a schematic illustration (not to scale) illustrating the encasing of the assembled together PCB assembly 300, e-textiles 108, 110, and clamping bar 500 in a casing (performed at step s12), and the filling of that casing (performed at step s14).

In this embodiment, the casing comprises an upper case half 702 and a lower case half 704. In this embodiment, at step s12, the upper and lower case halves 702, 704 are joined together to define an interior cavity in which the assembled together PCB assembly 300, e-textiles 108, 110, and clamping bar 500 are located. In other words, the case halves 702, 704 are brought together about the assembly comprising the PCB assembly 300, e-textiles 108, 110, and clamping bar 500, from opposing side of that assembly. The case halves 702, 704 are subsequently joined together, for example using rivets and/or by welding, to form a sealed casing.

Preferably, the casing is has dimensions such that, when the upper and lower case halves 702, 704 enclose the assembly comprising the PCB assembly 300, e-textiles 108, 110, and clamping bar 500, the casing forces the clamping bar 500 against the PCB assembly 300. This advantageously tends to improve electrical connection between the conductors 402 and the conductive tracks 304.

In this embodiment, portions the first and second e-textiles 108, 110 extend outward from the casing for attachment to the power supply 104 and connector 106 respectively.

In this embodiment, the upper and lower case halves 702, 704 are made of a metal, such as aluminium.

The upper case half 702 comprises an opening 706. In this embodiment, at step s14 a potting compound 708 is injected through the opening 706, thereby to fill the interior cavity of the casing in which the assembled together PCB assembly 300, e-textiles 108, 110, and clamping bar 500 are located. The potting compound 708 is a plastic resin which is injected into the casing as a liquid, and which subsequently solidifies within the casing. The potting compound 708 is an electrically resistive material. Preferably, the potting compound 708 is a thermally conductive material.

At step s16, the opening 708 of the casing is sealed.

Thus, a method of constructing the management module 102 is provided.

Advantageously, the casing and the solidified potting compound 708 tend to protect the PCB assembly 300, the e-textiles 108, 110 and the clamping bar 500 from damage.

The casing being made of an electrically conductive material, which in this embodiment is a metal, tends to provide the PCB assembly 300 and the e-textiles 108, 110 connected thereto with at least some degree of electromagnetic shielding.

The solidified potting compound 708 filling the interior cavity of the casing tends to prevent or oppose moisture from impinging on the components containing in the casing. The potting compound 708 tends to prevent or oppose water ingress along the e-textiles 108, 110 to the PCB assembly 300.

The solidified potting compound 708 filling the interior cavity of the casing tends to provide at least some strain relief to the e-textiles 108, 110 as at least a portion of the e-textiles 108, 110 are embedded within the potting compound 708.

The solidified potting compound 708 being thermally conductive advantageously tends to provide that heat is transferred away from the PCB assembly 300 and the e-textiles 108, 110 attached thereto, to the casing. Thus, cooling of the PCB assembly 300 tends to be provided.

Preferably, the coefficients of expansion of the components of the management module 102 (for example, including the PCB assembly 300, the potting compound 708, and the casing) are matched, i.e. are substantially equal to each other. This tends to provide for improved performance of the management module 102 and tends to reduce the likelihood of electrical disconnection between the e-textiles 108, 110 and the PCB assembly 300.

In the above embodiments, the management module, power source, and the connector are implemented on a tactical vest. However, in other embodiments, the management module, power source, and connectors are implemented on a different article, for example a different wearable item such as trousers, a bodysuit, a helmet, or a backpack. In some embodiments, the components of the system are distributed across multiple different articles.

In the above embodiment, the tactical vest comprises a single power source, a single management module, and a single connector. The power source, the management module, and the connector are connected together via two e-textiles components. However, in other embodiments, an article comprises a different number of power sources, management modules, and/or connectors. Also, in other embodiments, an article comprises a different number of e-textile components. For example, in some embodiments, the article comprises multiple connectors coupled to a common management module by respective e-textiles. In some embodiment, the article comprises one or more different types of components instead of or in addition to one or more of the power source, the management module, and the connector.

In the above embodiments, the e-textile and the PCB assembly comprise alignment holes, and the clamping bar comprises locator pins that are pushed through the alignment holes. However, in other embodiments, the components may be aligned and fixed together in a different appropriate way. For example, in some embodiments, the e-textile and the clamping bar comprise alignment holes, and the PCB assembly comprises locator pins that are pushed through the alignment holes.

## Claims

1. A method of electrically connecting an electronic textile (108, 110) to an electronic device (300), the electronic textile (108, 110) comprising an electrically insulating textile carrier (400) and one or more electrical conductor lines (402), the method comprising:
positioning the electronic textile (108, 110) relative to the electronic device (300) such that each conductor line (402) is in contact with an electrical conductor (304) of the electronic device (300), thereby providing an assembly; and
fixing a clamp member (500) to the assembly such that each conductor line (402) is sandwiched between the clamp member (500) and an electrical conductor (304) of the electronic device (300).

2. A method according to claim 1, wherein fixing the clamp member (500) to the assembly is such that the clamp member (500) applies a force to each conductor line (402) so as to push each conductor line (402) against an electrical conductor (304) of the electronic device (300).

3. A method according to claim 1 or 2, wherein the clamp member (500) comprises one or more grooves (600), and fixing the clamp member (500) to the assembly is such that each conductor line (402) is located within a respective groove (600).

4. A method according to any of claims 1 to 3, wherein the clamp member (500) comprises one or more deformable protrusions (604), and fixing the clamp member (500) to the assembly is such that each deformable protrusion (604) is deformed by contacting with the assembly.

5. A method according to any of claims 1 to 4, wherein the clamp member (500) is an electrically insulating member.

6. A method according to any of claims 1 to 5, further comprising:
forming a plurality of first alignment holes (306) through the electronic device (300); and
forming a plurality of second alignment holes (404) through the electronic textile (108, 110); wherein
positioning the electronic textile (108, 110) relative to the electronic device (300) comprises positioning the electronic textile (108, 110) relative to the electronic device (300) is such that each first alignment hole (306) is aligned with a respective second alignment hole (404).

7. A method according to claim 6, wherein:
the clamp member (500) comprises a plurality of locator pins (502); and
fixing the clamp member (500) to the assembly comprises positioning each locator pin (502) through a respective pair of aligned first and second alignment holes (306, 404).

8. A method according to any of claims 1 to 7, wherein the clamp member (500) comprises one or more structurally weakened portions (504).

9. A method according to any of claims 1 to 8, further comprising:
forming an aperture (406) through the electronic textile (108, 110) by removing a portion of the textile (108, 110) carrier (400) thereby exposing an intermediate portion of each conductor line (402); wherein
the positioning of the electronic textile (108, 110) relative to the electronic device (300) is performed such that the exposed intermediate portion of each conductor line (402) is in contact with an electrical conductor (304) of the electronic device (300); and
the fixing of the clamp member (500) to the assembly is performed such that the exposed intermediate portion of each conductor line (402) is sandwiched between the clamp member (500) and an electrical conductor (304) of the electronic device (300).

10. A method according to any of claims 1 to 9, further comprising sealing at least part of the fixed together electronic textile (108, 110), electronic device (300), and clamping member within an interior cavity of a casing (702, 704), wherein the casing (702, 704) pushes together the at least part of the fixed together electronic textile (108, 110), electronic device (300), and clamping member (500) located therein.

11. A method according to claim 10, wherein the casing (702, 704) is electrically and thermally conductive.

12. A method according to claim 10 or 11, further comprising filling the interior cavity of the casing (702, 704) with a potting compound (708).

13. A method according to any of claims 10 to 12, wherein the potting compound (708) is an electrically insulating material.

14. A method according to any of claims 10 to 13, wherein the potting compound (708) is a thermally conductive material.

15. An electronic assembly comprising:
an electronic device (300);
an electronic textile (108, 110) comprising an electrically insulating textile carrier (400) and one or more electrical conductor lines (402); and a
clamp member (500); wherein
the electronic textile (108, 110) is positioned relative to the electronic device (300) such that each conductor line (402) is in contact with an electrical conductor (304) of the electronic device (300); and
the clamp member (500) is arranged such that each conductor line (402) is sandwiched between the clamp member (500) and an electrical conductor (304) of the electronic device (300).
